(19) Europäisches Patentamt
European Patent Office
Office européen des brevets

(11) EP 0 848 262 A2

(12) EUROPÄISCHE PATENTANMELDUNG

(43) Veröffentlichungstag:
17.06.1998 Patentblatt 1998/25

(51) Int. Cl.⁶: **G01R 33/028**, H03F 1/00

(21) Anmeldenummer: 97121607.2

(22) Anmeldetag: 08.12.1997

(84) Benannte Vertragsstaaten:
AT BE CH DE DK ES FI FR GB GR IE IT LI LU MC NL PT SE
Benannte Erstreckungsstaaten:
AL LT LV MK RO SI

(30) Priorität: 13.12.1996 DE 19651922

(71) Anmelder:
STN ATLAS Elektronik GmbH
D-28305 Bremen (DE)

(72) Erfinder:
• Bornhöfft, Wolfgang
21220 Seevetal (DE)
• Trenkler, Gerhard
22885 Barsbüttel (DE)

(54) **Anpassverstärker für eine Induktionssonde**

(57) Bei einem Anpaßverstärker für eine Induktionssonde, die im Wasser sich ausbreitende, niederfrequente, magnetische Wechselfelder von Schwimmkörpern erfaßt, mit einem Trennverstärker und einem frequenzgangbestimmenden Netzwerk, weist zwecks Rückgängigmachen der Dekorrelation der von der Induktionssonde ausgegebenen Meßwerte das Netzwerk einen Frequenz-Durchlaßbereich mit Bandpaßcharakteristik und ein Integrationsverhalten im Durchlaßbereich auf, das auf die Kompensation der durch die differenzierende Wirkung der Induktionssonde erzeugten Dekorrelation des Meßsignals der Induktionssonde abgestimmt ist.

Fig. 3

EP 0 848 262 A2

**Beschreibung**

Die Erfindung betrifft einen Anpaßverstärker für eine Induktionssonde zur Erfassung von magnetischen Wechselfeldern, die von im Wasser befindlichen Magnetfeldquellen, insbesondere Schwimmkörpern, abgestrahlt werden, der im Oberbegriff des Anspruchs 1 definierten Gattung.

Es ist bekannt, in Wasser sich ausbreitende magnetische Wechselfelder mittels Induktionssonden zu erfassen und durch eine geeignete Verarbeitung der von den Induktionssonden ausgegebenen Meßsignale Rückschlüsse auf die Magnetfeldquelle zu ziehen. Solche Magnetfelder werden beispielsweise von Schwimmkörpern generiert, die z.B. ein U-Boot oder ein Torpedo sein können. Bei einem U-Boot rühren solche magnetischen Wechselfelder beispielsweise von der Antriebsanlage, dem Elektromotor, den Korrosionsströmen, die durch den Propellerschlag moduliert werden, und von Datenverarbeitungsanlagen her, in denen Softwareprogramme mit unterschiedlichen Auslastungszyklen ablaufen und die innerhalb der Datenverarbeitungsanlage fließenden Ströme modulieren. Diese von einem solchen Schwimmkörper abgestrahlten primären magnetischen Wechselfelder sind niederfrequent und durch einen stochastischen Signalcharakter gekennzeichnet.

Mit solchen Sonden können Magnetfeldquellen im Wasser auf eine Distanz von mehreren hundert Metern detektiert werden. Bei Verwendung von mindestens zwei Induktionssonden ist es dabei möglich, aus den Meßsignalen beider Sonden Abstands- und Richtungsinformationen zur Magnetfeldquelle zu erhalten, die Magnetfeldquelle also zu orten, wozu die am Ausgang solcher Induktionssonden anstehenden Meßsignale im Verhältnis zueinander bewertet werden müssen. Das Meßsignal einer Induktionssonde entspricht der zeitlichen Differentiation der magnetischen Induktion. Dabei werden die im erfaßten Wechselfeld der magnetischen Induktion enthaltenen stochastischen Signalanteile dekorreliert. Werden diese dekorrelierten Signalanteile nunmehr im Verhältnis zueinander bewertet, so führt dies zu extremen Ortungsfehlern. Um solche Ortungsfehler zu vermeiden, ist es daher unerläßlich, den Gleichlauf der mindestens zwei Induktionssonden hinsichtlich ihres Amplituden- und Phasenverhaltens sicherzustellen.

Da den Sonden üblicherweise auch ein Anpaßverstärker nachgeschaltet ist, ist bei der Bewertung der Ausgangssignale zweier Sonden auch ein unbedingter Gleichlauf der Anpaßverstärker erforderlich. Ein bekannter Anpaßverstärker der eingangs genannten Art (DE 26 25 964 C3) weist eine als Trennverstärker wirkende Eingangsstufe, einen $16\frac{2}{3}$ Hz-Saugkreis zur Unterdrückung von Störungen aus dem Fahrbetrieb elektrischer Eisenbahnlokomotiven und ein 10 Hz-Tiefpaßfilter zur Unterdrückung höherfrequenter Signalanteile, wie z.B. der Netzfrequenz 50 Hz, auf. Alle drei Stufen sind mit rauscharmen, integrierten Halbleiterverstärkern realisiert. Ein solcher Anpaßverstärker ist nicht in der Lage, der in der Induktionssonde erfolgenden Dekorrelation stochastischer Signalanteile entgegenzuwirken.

Der Erfindung liegt die Aufgabe zugrunde, einen Anpaßverstärker der eingangs genannten Art für Induktionssonden zur Erfassung von insbesondere niederfrequenten Wechselfeldern zu schaffen, der die von der Induktionssonde abgegebenen Meßsignale so verstärkt, daß diese amplituden- und phasentreu ins Verhältnis zueinander gesetzt werden können und die Bewertung dieses Verhältnisses zu brauchbaren Meßergebnissen mit geringer Fehlertoleranz führt.

Die Aufgabe ist bei einem Anpaßverstärker der im Oberbegriff des Anspruchs 1 angegebenen Gattung erfindungsgemäß durch die Merkmale im Kennzeichenteil des Anspruchs 1 gelöst.

Der erfindungsgemäße Anpaßverstärker hat den Vorteil, daß die durch das Differentiationsverhalten der Induktionssonde bedingte Dekorrelation der Meßsignale im Anpaßverstärker durch Einschränkung des Frequenzbereichs auf einen ausgewählten Durchlaßbereich und durch das Integrationsverhalten des Netzwerks im Durchlaßbereich wieder rückgängig gemacht wird. Damit können die im Anpaßverstärker solchermaßen kompensierten Meßsignale amplituden- und phasentreu für eine Mehrzahl von im Durchlaßbereich liegenden Frequenzintervallen oder - fenstern ins Verhältnis gesetzt werden und damit z.B. durch Summen- und Differenzbildung und anschließender Quotientenbildung aus Summe und Differenz der kompensierten Meßsignale von zwei Induktionssonden die Entfernung zur Magnetfeldquelle relativ genau bestimmt werden.

Zweckmäßige Ausführungsformen des erfindungsgemäßen Anpaßverstärkers mit vorteilhaften Weiterbildungen und Ausgestaltungen der Erfindung ergeben sich aus den weiteren Ansprüchen.

Die Erfindung ist anhand eines in der Zeichnung dargestellten Ausführungsbeispiels im folgenden näher beschrieben. Es zeigen:

Fig. 1        Ein Blockschaltbild einer Meßvorrichtung zur Erfassung von niederfrequenten magnetischen Wechselfeldern,

Fig. 2        ein Diagramm eines typisierten Beispiels des Frequenzgangs eines Anpaßverstärkers in der Meßvorrichtung in Fig. 1,

Fig. 3 und 4        jeweils ein Schaltbild eines Anpaßverstärkers in der Meßvorrichtung in Fig. 1 gemäß zweier Ausführungsbeispiele.

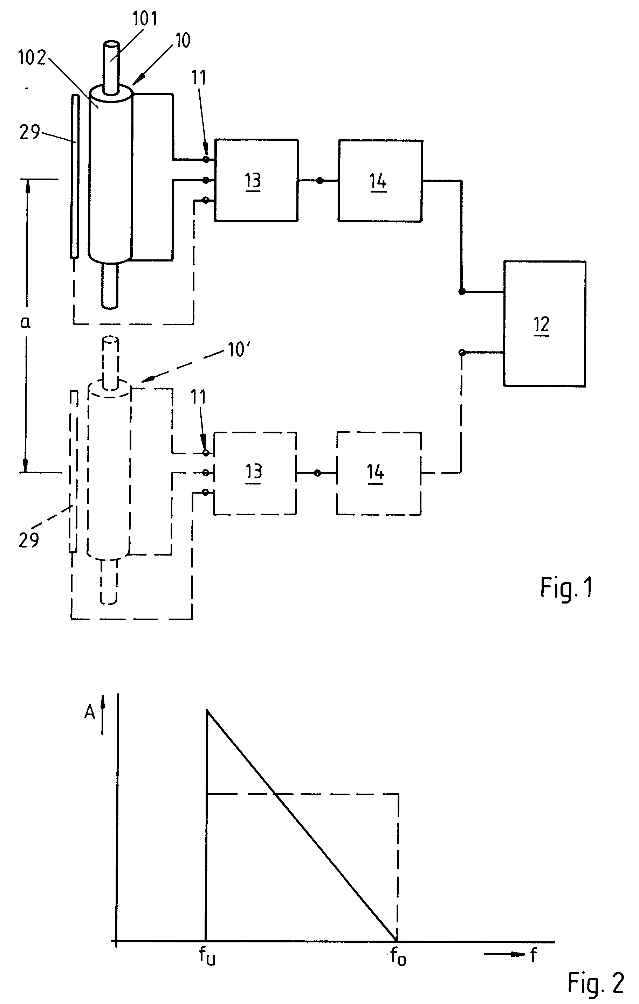

Die in Fig. 1 im Blockschaltbild dargestellte Meßvorrichtung zur Erfassung von niederfrequenten magnetischen Wechselfeldern, wie sie von Schwimmkörpern, wie U-Boot oder Torpedo, ins Wasser abgestrahlt werden, weist mindestens eine Induktionssonde 10 mit einem hochpermeablen Sondenkern 101 und einer den Sondenkern 101 umschließenden Meßwicklung 102 auf, die im Aufbau und in der Wirkungsweise beispielsweise in der DE 26 25 964 beschrieben ist. Diese Induktionssonde 10 mißt die Induktion des magnetischen Wechselfeldes und erzeugt an ihrem Spannungsausgang 11 entsprechende Meßsignale, aus denen mittels einer Signalverarbeitungselektronik 12 Informationen über die das magnetische Wechselfeld abstrahlende Magnetfeldquelle ermittelt werden. Der Meßausgang 11 der Induktionssonde 10 ist hierzu über einen Anpaßverstärker 13 und einen Analog-Digital-Wandler 14 mit der Signalverarbeitungselektronik 12 verbunden. Soll die Magnetfeldquelle mittels der Meßvorrichtung auch geortet, also ihr Ort nach Entfernung und Richtung zur Meßvorrichtung bestimmt, werden, sind in der Meßvorrichtung mindestens zwei Induktionssonden 10, 10' in einem definierten Abstand a voneinander anzuordnen, wobei der Meßausgang 11 jeder Induktionssonde 10, 10' über einen separaten Anpaßverstärker 13 und einen separaten Analog-Digital-Wandler 14 mit der Signalverarbeitungselektronik 12 verbunden sind. Die erforderliche zweite Induktionssonde 10' ist in Fig. 1 strichliniert angedeutet. Das am Meßausgang 11 der Induktionssonde 10 anstehende Meßsignal entspricht der zeitlichen Ableitung der magnetischen Induktion entsprechend

$$U_{Sonde} \sim \frac{dB(t)}{dt} \qquad\qquad (1),$$

wobei B(t) die magnetische Induktion und $U_{Sonde}$ das am Meßausgang 11 der Induktionssonde 10 als Spannungssignal vorliegende Meßsignal ist. Bedingt durch diese Differentiation der magnetischen Induktion B(t) werden die in B(t) enthaltenen stochastischen Signalanteile dekorrelliert.

Der Anpaßverstärker 13 weist einen als Trennverstärker wirkenden Operationsverstärker und ein frequenzgangbestimmendes Netzwerk auf. Um die vorstehend beschriebene Dekorrelation der stochastischen Signalanteile zu kompensieren, hat das den Frequenzgang bestimmende Netzwerk Bandpaßcharakteristik mit einem Durchlaßbereich zwischen einer unteren Frequenz $f_u$ und einer oberen Frequenz $f_O$ und weist im Durchlaßbereich Integrationsverhalten auf, wodurch das Meßsignal der Induktionssonde 10 entsprechend

$$B(t) = \int U_{Sonde} \cdot dt = \int \frac{dB(t)}{dt} dt \qquad\qquad (2)$$

kompensiert wird. Ein typisiertes Beispiel des Frequenzgangs des Netzwerks mit seiner Bandpaßcharakteristik zwischen den Frequenzgrenzen $f_u$ und $f_o$ und dem zusätzlich eingeführten, integrierenden Verhalten ist in Fig. 2 dargestellt. In einer bevorzugten Ausführungsform des Anpaßverstärkers 13 wird die untere Grenzfrequenz $f_u$ mit ca. 0,1 Hz und die obere Grenzfrequenz $f_o$ mit ca. 30 Hz festgelegt.

Der Anpaßverstärker 13 mit Trennverstärker und Netzwerk wird so ausgeführt, daß er einen extrem hohen Eingangswiderstand, eine bezogen auf die Eigenkapazität der Induktionssonde 10 geringe Eingangskapazität und ein minimales Eigenrauschen besitzt, das wesentlich niedriger ist als das von der Induktionssonde 10 erzeugte Widerstandsrauschen. Außerdem wird der integrierende Teil des Netzwerks so ausgelegt, daß der Verstärkerausgang durch im Meßsignal enthaltene Störsignale der Frequenz $16\frac{2}{3}$ Hz und ein Vielfaches davon nicht übersteuert wird.

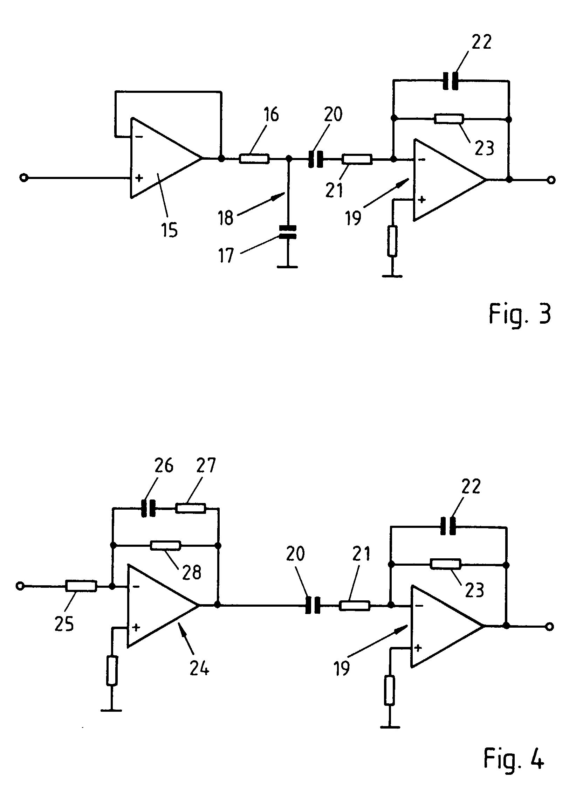

Ein Ausführungsbeispiel des Anpaßverstärkers 13 mit Trennverstärker und Netzwerk ist in Fig. 3 dargestellt. Der Operationsverstärker ist hier als Elektrometerverstärker 15 ausgebildet, dem ein aus einem Widerstand 16 und einem Kondensator 17 bestehendes Integrationsglied 18 nachgeschaltet ist. An dem Integrationsglied 18 ist ein Verstärker 19 mit Bandpaßcharakteristik angeschlossen, dessen negierter Eingang über eine Reihenschaltung aus Kondensator 20 und Widerstand 21 mit dem Integrationsglied 18 verbunden ist. Im Rückführungszweig des Verstärkers 19 ist eine Parallelschaltung aus Kondensator 22 und Widerstand 23 angeordnet. Der Meßausgang 11 der Induktionssonde 10 ist direkt an den nichtinvertierenden Eingang des Elektrometerverstärkers 15 angeschlossen. Bei Verwendung eines FET-Operationsverstärkers wird die Induktionssonde 10 nicht belastet und damit ihr Frequenzgang nicht verändert.

Bei dem in Fig. 4 dargestellten Ausführungsbeispiel des Anpaßverstärkers 13 ist der Elektrometerverstärker 15 durch einen integrierenden Verstärker 24 ersetzt, so daß sich eine Reihenschaltung aus dem integrierenden Verstärker 24 und dem Verstärker 19 mit Bandpaßcharakteristik ergibt. Der Verstärker 19 mit Bandpaßcharakteristik ist identisch wie in Fig. 3 ausgeführt, so daR gleiche Bauelemente mit gleichen Bezugszeichen versehen sind. Der Meßausgang 11 der Induktionssonde 10 ist über einen Widerstand 25 an den invertierenden Eingang des Verstärkers 24 geführt, dessen integrierendes Verhalten durch die Ausbildung des Rückführungszweigs erreicht ist, in dem eine Reihenschaltung aus einem Kondensator 26 und aus einem Widerstand 27 einem Widerstand 28 parallelgeschaltet ist. Eine solche Ausführung des Anpaßverstärkers 13 wird besonders bevorzugt, da hier der Anpaßverstärker 13 mit einem hohen Eingangswiderstand, der z.B. einhundertmal größer ist als der Innenwiderstand der Induktionssonde 10, und mit einer geringen Eingangskapazität, die z.B. nur das 0,1fache der Sondenkapazität beträgt, ausgestattet werden kann. Außerdem kann der in der Rückführung des integrierenden Verstärkers 24 sich befindliche, integrierende Netzwerkteil so ausgelegt werden, daß der Ausgang des Anpaßverstärkers 13 durch von der Induktionssonde 10 gemessene, umweltbedingte Störsignale z.B. der Frequenz $16\frac{2}{3}$ Hz (Bahnstromversorgung) und deren Vielfachen, z.B. 50 Hz (Energieversorgung), nicht übersteuert wird, d.h. in die Sättigung gefahren wird.

Der Anpaßverstärker 13 wird zweckmäßigerweise zusammen mit der Induktionssonde 10 in ein gemeinsames Gehäuses eingebaut. Vorzugsweise sollte die Stromversorgung mittels einer zugeordneten Batterie mit in das Gehäuse einbezogen werden, um störende Einflüsse, die von außen über etwaige Stromversorgungsleitungen in die Induktionssonde 10 einkoppeln könnten, zu unterdrücken. Bei Betrieb des Anpaßverstärkers 13 mit einer Batterie ist daher zur Erzielung einer langen Betriebsdauer der Stromverbrauch des Anpaßverstärkers 13 zu minimieren.

Um die Eigenkapazität der Induktionssonde 10 zu reduzieren, ist häufig die Induktionssonde 10 mit sog. Potentialflächen 29 ausgestattet. Solche Potentialflächen 29 können zwischen dem Sondenkern 101 und der Meßwicklung 102 oder zwischen der Meßwicklung 102 und dem Gehäuse, aber auch bei in Einzelspulen unterteilter Meßwicklung 102 zwischen den einzelnen Wicklungsspulen angeordnet werden. Zur Einstellung unterschiedlicher Potentiale an den Potentialflächen 29 ist dann im Anpaßverstärker 13 noch eine hier nicht dargestellte Funktionseinheit vorzusehen, die mit den Potentialfächen 29 verbunden ist (wie dies in Fig. 1 strichliniert angedeutet ist), um an die Potentialflächen 29 die entsprechenden Spannungspotentiale anzulegen. Im einfachsten Fall ist diese Funktionseinheit als Spannungsteiler ausgebildet.

## Patentansprüche

1. Anpaßverstärker für eine Induktionssonde (10) zur Erfassung von magnetischen Wechselfeldern, die von im Wasser befindlichen Magnetfeldquellen, insbesondere Schwimmkörpern, abgestrahlt werden, mit einem einen Trennverstärker darstellenden Operationsverstärker und einem frequenzgangbestimmenden Netzwerk, dadurch gekennzeichnet, daß das Netzwerk einen Frequenz-Durchlaßbereich mit Bandpaßcharakteristik und ein Integrationsverhalten im Durchlaßbereich aufweist, das auf die Kompensation der durch die differenzierende Wirkung der Induktionssonde (10) erzeugten Dekorrelation des Meßsignals abgestimmt ist.

2. Anpaßverstärker nach Anspruch 1, dadurch gekennzeichnet, daR der Durchlaßbereich des Netzwerks auf ca. 0,1 Hz bis 30 Hz festgelegt ist.

3. Anpaßverstärker nach Anspruch 1 oder 2, dadurch gekennzeichnet, daß der integrierende Netzwerkteil in Signalflußrichtung hinter dem Operationsverstärker angeordnet ist.

4. Anpaßverstärker nach Anspruch 3, dadurch gekennzeichnet, daß der Operationsverstärker als Elektrometerverstärker (15) ausgebildet ist, dem ein aus einem Widerstand (16) und einem Kondensator (17) bestehendes Integrationsglied (18) nachgeschaltet ist und daß an dem Integrationsglied (18) ein Verstärker (19) mit Bandpaßcharakteristik angeschlossen ist.

5. Anpaßverstärker nach Anspruch 1 oder 2, dadurch gekennzeichnet, daß der integrierende Netzwerkteil in dem Rückführzweig des Operationsverstärkers angeordnet ist.

6. Anpaßverstärker nach Anspruch 5, dadurch gekennzeichnet, daß der integrierende Netzwerkteil so ausgelegt ist, daß der Verstärkerausgang durch im Meßsignal enthaltene Störsignale der Frequenz $16\frac{2}{3}$ Hz und einem Vielfachen davon nicht übersteuert wird.

7. Anpaßverstärker nach Anspruch 5 oder 6, gekennzeichnet durch die Reihenschaltung eines integrierenden Verstärkers (24) und eines Verstärkers (19) mit Bandpaßcharakteristik, wobei das Integrationsverhalten des integrierenden Verstärkers (24) auf das Frequenzband des Verstärkers (19) mit Bandpaßcharakteristik abgestimmt ist.

8. Anpaßverstärker nach einem der Ansprüche 1 bis 7, gekennzeichnet durch einen extrem hohen Eingangswiderstand.

9. Anpaßverstärker nach einem der Ansprüche 1 bis 8, gekennzeichnet durch minimales Eigenrauschen, das vorzugsweise wesentlich niedriger ist als das von der Induktionssonde (10) erzeugte Widerstandsrauschen.

10. Anpaßverstärker nach einem der Ansprüche 1 bis 9, gekennzeichnet durch eine bezogen auf die Eigenkapazität der Induktionssonde (10) geringe Eingangskapazität.

11. Anpaßverstärker nach einem der Ansprüche 1 bis 10, gekennzeichnet durch einen geringen Stromverbrauch.

12. Anpaßverstärker nach einem der Ansprüche 1 bis 11 für eine Potentialflächen zur Verringerung der Eigenkapazität aufweisende Induktionssonde (10), gekennzeichnet durch eine Funktionseinheit zur Erzeugung von unterschiedlichen Spannungspotentialen an den Potentialflächen (29).

13. Anpaßverstärker nach Anspruch 12, dadurch gekennzeichnet, daß die Funktionseinheit aus einem oder mehreren Spannungsteilern besteht.

14. Meßvorrichtung mit mindestens zwei im Abstand (a) voneinander angeordneten Induktionssonden (10, 10') zur Erfassung von magnetischen Wechselfeldern, die von im Wasser befindlichen Magnetfeldquellen, insbesondere Schwimmkörpern, abgestrahlt werden, gekennzeichnet durch einen jeweils einer Induktionssonde (10, 10') zugeordneten Anpaßverstärker (13) nach einem der Ansprüche 1 bis 13.

Fig. 1

Fig. 2

Fig. 3

Fig. 4